# FASCICULE DE BREVET EUROPEEN

(11) **EP 3 571 716 B1**
(45) Date de publication et mention de la délivrance du brevet: **15.09.2021**
(21) Numéro de dépôt: 18700943.6
(22) Date de dépôt: 05.01.2018
(51) Int. Cl.: H01L 23/373, H01L 21/48, H05K 1/03, H05K 1/02, H01L 23/498

(54) **PROCEDE DE FABRICATION D'UN MODULE ELECTRONIQUE DE PUISSANCE PAR FABRICATION ADDITIVE, SUBSTRAT ET MODULE ASSOCIES**
VERFAHREN ZUR HERSTELLUNG EINES LEISTUNGSELEKTRONISCHEN MODULS DURCH GENERATIVE FERTIGUNG, ZUGEHÖRIGES MODUL UND SUBSTRAT
PROCESS FOR MANUFACTURING A POWER ELECTRONIC MODULE BY ADDITIVE MANUFACTURING, ASSOCIATED MODULE AND SUBSTRATE

(30) Priorité: 18.01.2017 FR 1750381
(43) Date de publication de la demande: 27.11.2019
(73) Titulaire: Safran, 75015 Paris (FR)
(72) Inventeur: KHAZAKA, Rabih, 77550 Moissy-Cramayel (FR); AZZOPARDI, Stéphane, 77550 Moissy-Cramayel (FR); MARTINEAU, Donatien, Henri, Edouard, 77550 Moissy-Cramayel (FR)
(74) Mandataire: Cabinet Beau de Loménie
(86) Numéro de dépôt international: PCT/FR2018/050024
(87) Numéro de publication internationale: WO 2018/134495

(56) Documents cités:
- EP-A1- 2 991 105
- DE-A1-102014 203 309
- JP-A- H0 624 880
- JP-A- 2007 096 032
- US-A- 5 561 321
- US-A1- 2011 061 906

## Description

### Arrière-plan de l'invention

L'invention concerne la fabrication d'un substrat et d'un module électronique de puissance.

La présente invention trouve une application particulière dans le domaine de l'aéronautique où les contraintes thermiques peuvent être sévères.

Les modules électroniques de puissance sont compris dans des convertisseurs nécessaires pour l'électrification des systèmes propulsifs et non propulsifs à bord des aéronefs afin de convertir l'énergie électrique du réseau principal (115V AC, 230V AC, 540V DC...) sous plusieurs formes (AC/DC, DC/AC, AC/AC et DC/DC).

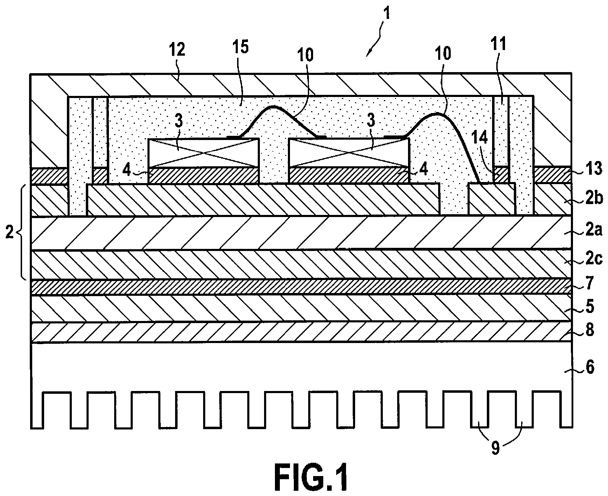

Sur la figure 1 est illustré un exemple de module électronique de puissance 1 connu de l'art antérieur.

Le module électronique de puissance 1 est composé d'un substrat 2 comprenant une couche électriquement isolante 2a, en matériau céramique, agencée entre deux couches métalliques 2b, 2c. Les deux couches métalliques sont assemblées à la couche électriquement isolante 2a par une des différentes techniques connues comme par exemple par brasage (ou en terminologie anglo-saxonne « Active Metal Brazing » ou encore « AMB »), par liaison direct du cuivre (ou en terminologie anglo-saxonne « Direct Bonded Copper » ou encore « DBC »), ou encore par liaison directe d'aluminium (ou en terminologie anglo-saxonne « Direct Bonded Aluminium » ou encore « DBA »).

La couche métallique supérieure 2b du substrat 2 forme un circuit de puissance sur lequel des composants à semi-conducteur de puissance 3 sont assemblés. Comme cela est illustré sur la figure 1, le module électronique de puissance 1 comprend un joint d'interconnexion électrique et/ou mécanique 4 et 14 par l'intermédiaire duquel les composants à semi-conducteur de puissance 3 et les connectiques 11 sont assemblés au circuit de puissance 2b. Du fait de leurs imperfections, les composants à semi-conducteurs de puissance 3 sont le siège de pertes par effet Joule et donc représentent une source importante de chaleur.

Les composants à semi-conducteurs de puissance 3 sont ensuite interconnectés électriquement entre eux et avec les connectiques 11 à l'aide des fils de câblage. Un boitier 12 généralement en polymère est ensuite collé à l'aide d'un joint adhésif 13 sur le substrat 2 ou sur une semelle 5 métallique sur laquelle est disposée le substrat 2. Le boitier 12 est ensuite rempli par un encapsulant 15, tel qu'un gel ou époxy, pour assurer une protection mécanique et électrique des composants de puissance 3 et des fils de câblage 10.

La couche métallique inférieure 2c du substrat 2 est rapportée sur la semelle 5 métallique qui a pour rôle d'étaler le flux thermique et d'assurer une connexion thermique avec un dissipateur thermique 6 métallique. Comme cela est illustré sur la figure 1, le module électronique de puissance 1 comprend un joint d'interconnexion électrique et/ou mécanique 7 par l'intermédiaire duquel la couche métallique 2c inférieure du substrat 2 est rapportée sur la semelle 5.

La semelle 5 est elle-même rapportée sur le dissipateur thermique 6 métallique par l'intermédiaire d'une couche 8 de matériau d'interface thermique, telle qu'une graisse thermique, un film élastomère, ou de matériaux à changement de phase. La couche 8 de matériau d'interface thermique permet de réduire la résistance thermique de contact entre la semelle 5 et le dissipateur thermique 6 pour assurer une meilleure évacuation du flux thermique. Le dissipateur thermique 6, est muni d'ailettes 9 permettant de réduire d'autant plus la résistance thermique de ce dernier, les ailettes 9 étant traversées par un fluide de refroidissement, par exemple de l'air.

Un tel module électronique de puissance 1 présente cependant plusieurs inconvénients.

La couche électriquement isolante 2a du substrat 2 ainsi que la couche 8 de matériau d'interface thermique sont des couches à forte résistance thermique et donc à mauvaise conduction thermique. Elles limitent ainsi la dissipation thermique générée au sein des composants à semi-conducteur de puissance 3 vers le dissipateur thermique 6 et le fluide de refroidissement. Par ailleurs, la couche 8 de matériau d'interface thermique induit une résistance thermique non homogène, qui dépend du positionnement des composants à semi-conducteurs de puissance 3 sur le circuit de puissance, notamment si ce dernier présente un défaut de planéité. La multiplicité des couches 2a, 2b, 2c, 4, 5, 7, 8 entre les composants à semi-conducteur de puissance 3 et le dissipateur thermique 6 contribue également à cette forte résistance thermique. Le refroidissement du module électronique de puissance 1 est donc limité et le module électronique de puissance 1 n'est pas adapté pour des applications à hautes températures, c'est-à-dire à des températures ambiantes supérieures ou égales à 175°C du fait de la présence de matériaux organiques (matériaux d'interface thermique, l'encapsulant, le joint adhésif et le boitier) qui se dégradent généralement rapidement au-delà de 175 °C. Notons que les composants à semi-conducteurs grand gap (SiC, GaN,...) peuvent fonctionner au-delà des limites classiques des composants en Si (175°C) et afin de profiter de l'opportunité de fonctionner à haute température, tous les éléments constituants le module électronique de puissance doivent être capables de fonctionner d'une façon fiable à haute température.

Par ailleurs, les solutions d'assemblage des différentes couches 2a, 2b, 2c, 5 ayant des coefficients de dilatation thermique différents entre elles rendent le module électronique de puissance 1 sensible au phénomène de fatigue thermique, limitant de ce fait la fiabilité du module électronique de puissance 1. Ces solutions peuvent par exemple entrainer des fissures dans la couche électriquement isolante 2a du substrat 2 et/ou dans les joints d'interconnexion électriques 4, 7.

En outre, les gravures appliquées sur la couche métallique 2b supérieure du substrat 2 créent une asymétrie avec la couche métallique 2c inférieure par rapport à la couche électriquement isolante 2a. Cela a pour effet, lors d'une montée en température, par exemple lorsque les composants à semi-conducteur de puissance 3 sont assemblés au substrat 2 ou lorsque le substrat 2 est assemblé à la semelle 5 ou lors d'une phase opérationnelle du module électronique de puissance 1, d'induire des contraintes thermomécaniques dans le substrat 2 entraînant sa déformation. Cette déformation est appelée flèche et correspond à une cambrure du substrat 2.

Une telle flèche du substrat 2 va créer un vide qui peut être compensé par la couche 8 de matériau d'interface thermique. Toutefois, comme précédemment expliqué, cette couche 8 limite la dissipation thermique entre les composants à semi-conducteur de puissance 3 et le dissipateur thermique 6 et induit une résistance thermique non homogène qui dépend du positionnement des composants à semi-conducteurs de puissance 3 sur le circuit de puissance. On ne peut donc pas compenser la flèche du substrat 2 en augmentant l'épaisseur de la couche 8 de matériau d'interface thermique sans détériorer davantage la dissipation thermique au sein du module électronique de puissance 1.

JP 2007 096032 A décrit un procédé de fabrication d'un module électronique de puissance par fabrication additive.

US 2011/061906 A1 décrit un substrat pour un module électronique de puissance.

### Objet et résumé de l'invention

L'invention vise à pallier les inconvénients des modules électroniques de puissance mentionnés ci-dessus.

Un objet de l'invention propose un procédé de fabrication d'un module électronique de puissance par fabrication additive, le module électronique comprenant un substrat comportant une plaque isolante, telle qu'une plaque de céramique, présentant une première et une seconde faces opposées, et une première couche métallique disposée directement sur la première face de la plaque isolante et une seconde couche métallique disposée directement sur la seconde face de la plaque isolante.

Selon une caractéristique générale de l'invention, au moins une des couches métalliques est réalisée par une étape de dépôt d'une couche mince de métal et une étape de recuit de la couche métallique, généralement à une température de l'ordre de 700°C, et le procédé comprend en outre une étape de formation d'au moins une couche de transition thermomécanique sur au moins l'une des première et seconde couches métalliques, ladite au moins une couche de transition thermomécanique comportant un matériau présentant un coefficient de dilatation thermique (CTE) inférieur à celui du cuivre.

L'étape de dépôt d'une couche mince de métal peut comprendre un dépôt par sérigraphie ou un dépôt d'une couche métallique mince à partir d'une pâtes ou d'une encre en utilisant des techniques dites en anglais de « direct writing process » telles que les techniques suivantes par exemple : « inkjet process », « extrusion based process », « aerosol based process ».

La couche de transition thermomécanique du substrat selon l'invention permet, grâce au CTE réduit qu'elle présente par rapport à la couche métallique, d'augmenter la fiabilité thermomécanique du substrat comparé à un substrat à liaison directe de cuivre (DBC), et elle permet de limiter les problèmes liés à la cambrure des substrats, observés pour des substrats céramiques (DBC et AMB).

Le procédé de fabrication utilisant une fabrication additive pour chaque étape de formation d'une nouvelle couche du substrat, le procédé permet d'éviter toute perte de matière lors de la fabrication du module électronique de puissance grâce au dépôt et à la fusion sélective des couches.

La fabrication additive (FA), nommée aussi impression 3D, est une technique permettant de réaliser des objets en faisant ajouter des couches successives. Une source de puissance vient amener de l'énergie dans des endroits bien définis à la poudre déposée par couche mince (typiquement<100µm) pour l'agglomérer. La succession de dépôt de couches et de leur agglomération sélective permet ainsi de construire un matériau dense avec une forme bien définie. La sélectivité des parties agglomérées, permet ainsi de donner à l'objet directement la forme souhaitable même si cette dernière est complexe. Elle permet aussi de limiter les pertes en matériaux qui peuvent être extrêmement désirable pour les matériaux chers et rares.

En effet, dans le cas d'un substrat classique de l'état de la technique, les couches de cuivre Cu de la face supérieure et inférieure couvrent complètement la surface de la céramique et sont reportées en direct sur la céramique en utilisant la technologie DBC ou en utilisant la technologie de brasage AMB. Une étape de gravure permet ensuite d'enlever le cuivre Cu localement sur la face supérieure et de réaliser des pistes non connectées électriquement servant comme circuit électrique.

Selon un premier aspect du procédé, ladite au moins une couche de transition thermomécanique peut être déposée par dépôt d'un lit de poudre de matériau ou par projections de poudre de matériau, la poudre déposée étant figée ensuite par balayage d'une source de puissance calorifique sous atmosphère inerte.

Typiquement dans les substrats de l'état de la technique, l'épaisseur de la céramique est entre 300µm et 1000µm et l'épaisseur de cuivre entre 200 µm et 500 µm. Or, il a été démontré que plus l'épaisseur de cuivre est élevée, moins le substrat est fiable lors des cycles thermiques conduisant de fortes contraintes thermomécaniques.

La fabrication additive utilisée par le procédé selon l'invention permet de réaliser et d'utiliser des couches de cuivre minces, c'est-à-dire inférieures à 100 µm et plus particulièrement comprises entre 20 µm et 50 µm, offrant une meilleure fiabilité. En outre, la superposition des couches de transition thermomécanique en matériau différent du cuivre permet d'augmenter l'épaisseur des pistes et ainsi d'augmenter le courant acceptable dans les pistes sans limiter la fiabilité des substrats.

L'utilisation des métaux en fabrication additive nécessite en général une source de puissance permettant d'amener une puissance nécessaire, par exemple allant de 100 W à 1 kW, pour faire fondre ou fritter la poudre métallique déposée pendant le procédé de fabrication additive sous forme d'un lit de poudre ou par projection de poudre localisée. La source de puissance (faisceau laser ou faisceau d'électrons) vient cibler les zones où il est souhaitable d'avoir du matériau dense afin d'avoir à chaque passage une couche densifiée et figée.

L'épaisseur typique d'une couche déposée peut varier entre 20 µm et 150 µm. Une nouvelle couche est ensuite déposée et figée par un balayage de la source de puissance sur la zone à figer. La succession des étapes de dépôt de couches et leur densification permettent d'obtenir l'objet avec la forme désirée.

Selon un deuxième aspect du procédé, le CTE des matériaux utilisées pour les couches de transition thermomécanique est compris entre 3 ppm/°C et 17 ppm/°C.

Les couches de transition thermomécanique présentent ainsi un CTE compris entre celui de la couche métallique et le CTE des composants à semi-conducteurs de puissance destinés à être montés sur le module électronique de puissance.

Selon un troisième aspect du procédé, le substrat comprend, sur au moins une des première et seconde faces de la plaque isolante, un empilement d'une couche métallique et d'une pluralité de couches de transition thermomécanique, ledit au moins un empilement présentant un gradient de CTE.

Cette adaptation de CTE entre le cuivre et les composants à semi-conducteurs de puissance permet de minimiser les contraintes mécaniques lors des cycles thermiques dans la céramique et dans le joint d'interconnexion entre le métal et le semi-conducteur respectivement, le joint d'interconnexion correspondant à la brasure pour monter le semi-conducteur sur les couches de transition thermique et d'obtenir ainsi une meilleure fiabilité des modules électroniques de puissance.

Selon un quatrième aspect du procédé, le procédé comprend en outre une étape de formation d'un radiateur par fabrication additive à partir de la dernière couche de transition thermomécanique de la seconde face du substrat, la seconde face du substrat comprenant la seconde couche de cuivre.

La formation par fabrication additive d'une zone de transition thermomécanique comprenant un radiateur permet de diminuer la résistance thermique du module électronique de puissance et d'éliminer le matériau d'interface thermique utilisé dans l'état de la technique. Le matériau d'interface thermique est généralement une graisse thermique. La suppression de l'interface thermique permet d'éliminer les points faibles qui lui sont associés relatifs notamment à sa faible conductivité thermique et sa dégradation à haute température.

Cela a également pour conséquence de permettre l'utilisation du module électronique de puissance à de très hautes températures et à de fortes puissances.

En outre, la fabrication du radiateur par fabrication additive offre la possibilité de fabriquer des radiateurs avec des géométries complexes permettant un refroidissement efficace sous air et souvent trop complexes à réaliser avec les technologies classiquement connues pour la fabrication des radiateurs.

Selon un cinquième aspect du procédé, le procédé comprend en outre, une étape de réalisation d'un boîtier apte à protéger les composants électroniques destinés à être montés sur la première face du substrat et de réalisation des connectiques aptes à raccorder électriquement le module électronique à des éléments électriques externes, le boîtier et les connectiques étant réalisés par fabrication additive à partir de la dernière couche de transition thermomécanique de la première face du substrat, la première face du substrat comprenant la première couche de cuivre.

La réalisation du boîtier par fabrication additive à partir de la dernière couche de transition thermomécanique du substrat offre la possibilité de réaliser des boîtiers hermétiques avec des isolations (gaz isolant avec ou sans pression, vide poussé, liquide isolant, etc.) différentes de celles assurées par des matériaux organiques utilisés classiquement tels que les gels ou époxy.

En outre, la fabrication du boitier métallique par impression 3D permet de supprimer les polymères présents dans l'état de la technique dans les joints adhésifs utilisés pour coller le boitier, dans le boitier et le gel silicone encapsulant les composants électroniques.

La suppression des polymères qui présentent une faible stabilité thermique à des températures supérieures à 175°C et la suppression du matériau d'interface thermique permettent une utilisation du module électronique de puissance dans des températures supérieures à 200 °C.

Des modules électroniques de puissance fonctionnant dans cette gamme de température sont particulièrement intéressants pour des applications aéronautiques, vu qu'ils permettent de ramener l'électronique de commande au plus proche des sources chaudes que sont par exemple les freins ou le moteur, pour avoir des systèmes plus intégrés et pouvoir gagner ainsi en volume.

L'augmentation de la température environnante autorisée permet également de réduire les dimensions du système de refroidissement et ainsi d'augmenter la densité de puissance du convertisseur de puissance.

Le boitier métallique permet également d'assurer un blindage électromagnétique du module électronique de puissance et réduisant ainsi l'effet des perturbations électromagnétiques externes sur les composants électroniques du module.

Un autre objet de l'invention propose un substrat pour module électronique de puissance, le substrat comprenant une plaque isolante présentant une première et une seconde faces opposées, et une première couche métallique disposée directement sur la première face de la plaque isolante et une seconde couche métallique disposée directement sur la seconde face de la plaque isolante. Le substrat comprend, sur au moins l'une des première et seconde couches métalliques, au moins une couche de transition thermomécanique comportant un matériau présentant un coefficient de dilatation thermique inférieur à celui du métal de la couche métallique.

Encore un autre objet de l'invention propose un module électronique de puissance comprenant un substrat présentant une première face et une seconde face opposée à la première face, et un radiateur monté sur la seconde face du substrat, la première face du substrat étant destinée à recevoir des composants électroniques, le substrat correspondant au substrat tel que défini ci-dessus.

### Brève description des dessins.

L'invention sera mieux comprise à la lecture faite ci-après, à titre indicatif mais non limitatif, en référence aux dessins annexés sur lesquels :
- la figure 1, déjà décrite, illustre un exemple de module électronique de puissance connu de l'art antérieur ;
- la figure 2 présente une représentation schématique d'un module électronique de puissance selon un mode de réalisation de l'invention ;
- la figure 3 présente un logigramme d'un procédé de fabrication d'un module électronique de puissance selon un mode de mise en œuvre de l'invention.

### Description détaillée de modes de réalisation

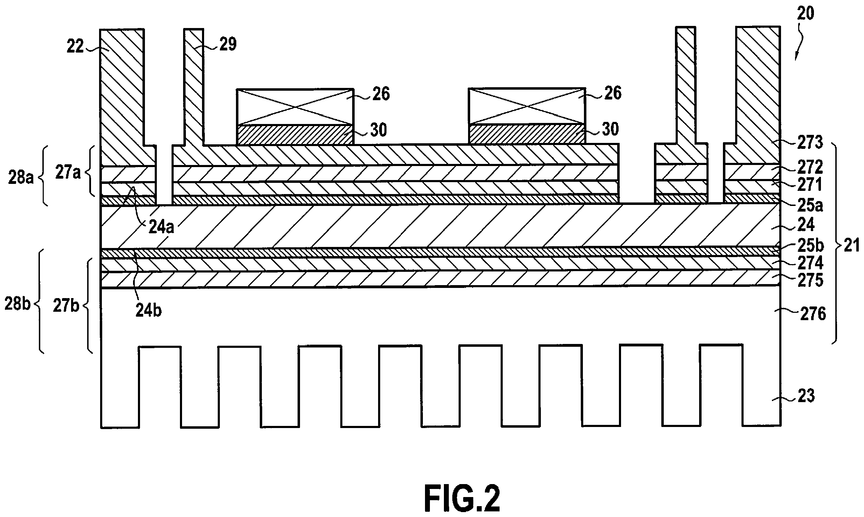

Sur la figure 2 est représenté schématiquement un module électronique de puissance 20 selon un mode de réalisation de l'invention.

Le module électronique de puissance 20 comprend un substrat 21, un boîtier 22 et un radiateur 23.

Le substrat 21 comprend une plaque isolante 24 en céramique, Al₂O₃ ou AlN par exemple, présentant une première face 24a et une seconde face 24b opposée à la première face 24a. La plaque isolante 24 comprend en outre une première couche de cuivre 25a et une seconde couche de cuivre 25b déposées par sérigraphie, respectivement sur la première face 24a et sur la seconde face 24b de la plaque isolante 24, et ayant subie un recuit. La première couche de cuivre 25a forme des pistes électriquement conductrices destinées à être raccordées à des composants électroniques 26, et la seconde couche de cuivre 25b forme des pistes thermiquement conductrices destinées à être thermiquement couplée au radiateur 23.

Le substrat 21 comprend également une première superposition 27a de couches de transition thermomécanique et une seconde superposition 27b de couches de transition thermomécanique.

La première superposition 27a est disposée sur la première couche de cuivre 25a. Elle comprend, dans le mode de réalisation illustré, trois couches de transition thermomécanique référencées 271 à 273, chaque couche de transition thermomécanique 271 à 273 étant formée par fabrication additive à partir d'un matériau électriquement conducteur présentant un coefficient de dilatation thermique, noté également CTE pour l'expression anglaise « coefficient of thermal expansion », inférieur à celui du cuivre qui est généralement de l'ordre de 17 ppm/°C.

Dans le mode de réalisation illustré sur la figure 2, la première couche de transition thermomécanique 271 de la première superposition 27a présente un CTE de l'ordre de 13 ppm/°C, la deuxième couche de transition thermomécanique 272 présente un CTE de l'ordre de 10 ppm/°C et la troisième couche de transition thermomécanique 273 présente un CTE de l'ordre de 7 ppm/°C. La première couche de transition thermomécanique 271 de la première superposition 27a est comprise entre la première couche de cuivre 25a et la deuxième couche de transition thermomécanique 272, et la deuxième couche de transition thermomécanique 272 est comprise entre la première couche thermomécanique 271 et la troisième couche de transition thermomécanique 273.

La première couche de cuivre 25a et la première superposition 27a forme ainsi un premier empilement 28a présentant un gradient de CTE, le CTE diminuant en fonction de l'éloignement de la couche avec la première face 24a la plaque isolante 24 en céramique.

La seconde superposition 27b est disposée sur la seconde couche de cuivre 25b. Elle comprend, dans le mode de réalisation illustré, trois couches de transition thermomécanique référencées 274 à 276, chaque couche de transition thermomécanique 274 à 276 étant formée par fabrication additive à partir d'un matériau thermiquement conducteur présentant un CTE inférieur à celui du cuivre.

Dans le mode de réalisation illustré sur la figure 2, la première couche de transition thermomécanique 274 de la seconde superposition 27b présente un CTE de l'ordre de 13 ppm/°C, la deuxième couche de transition thermomécanique 275 présente un CTE de l'ordre de 10 ppm/°C et la troisième couche de transition thermomécanique 276 présente un CTE de l'ordre de 7 ppm/°C. La première couche de transition thermomécanique 274 de la seconde superposition 27b est comprise entre la seconde couche de cuivre 25b et la deuxième couche de transition thermomécanique 275, et la deuxième couche de transition thermomécanique 275 est comprise entre la première couche thermomécanique 274 et la troisième couche de transition thermomécanique 276.

La seconde couche de cuivre 25b et la seconde superposition 27b forme ainsi un second empilement 28b présentant un gradient de CTE, le CTE diminuant en fonction de l'éloignement de la couche avec seconde face 24b de la plaque isolante 24 en céramique.

Le substrat 21 comprend la plaque isolante de céramique 24, le premier empilement 28a et le second empilement 28b. Dans chacun des empilements 28a et 28b, le CTE varie à l'intérieur de l'empilement, dans le mode de réalisation illustré, entre 17 ppm/°C pour la couche de cuivre 25a ou 25b et un CTE supérieur ou égal à 3 à 4 ppm/°C pour se rapprocher du CTE de la plaque isolante 24 en céramique qui présente un CTE de 7 ppm/°C ou des composants électroniques 26 semi-conducteurs qui peuvent présenter un CTE de l'ordre de 3 à 4 ppm/°C.

Le gradient de CTE présenté par les premier et second empilements 28a et 28b du substrat permet d'améliorer la fiabilité du substrat et d'offrir une faible variation de cambrure en fonction de la température avec des métallisations épaisses.

Dans le mode de réalisation illustré sur la figure 2, le radiateur 23 du module électronique de puissance 20 est formé à partir de la troisième couche de transition thermomécanique 276 de la seconde superposition 27b.

Ainsi, le second empilement 28b comprend le radiateur et est entièrement réalisé par fabrication additive et présente un gradient de CTE, le CTE diminuant graduellement entre la seconde couche de cuivre 25b et le radiateur 23.

De manière similaire, le boîtier 22 du module électronique de puissance 20 est formé à partir de la troisième couche de transition thermomécanique 273 de la première superposition 27a. Le boîtier 22 permet d'encapsuler hermétiquement les composants électroniques 26 montés sur la troisième couche de transition thermomécanique 273 de la première superposition 27a.

Ainsi le premier empilement 28a comprend le boîtier 22 et est entièrement réalisé par fabrication additive, et présente un gradient de CTE, le CTE diminuant graduellement entre la première couche de cuivre 25a et le boîtier 22.

Le module électronique de puissance 20 comprend également des connectiques 29 permettant de raccorder le module électronique 20 à des éléments électriques extérieurs non représentés. Les connectiques 29 sont également formées à partir de la troisième couche de transition thermomécanique 273 de la première superposition 27a.

Pour des raisons de simplification et de clarté la figure 2, la partie formant le capot du boîtier 22 n'a pas été représentée, mais peut être également formée par fabrication additive étant donné qu'elle est partie intégrante du boîtier 22 ou faite séparément et attaché au boitier après.

Dans le mode de réalisation illustré sur la figure 2, les composants électroniques 26, notamment les composants semi-conducteurs, sont fixés et raccordés à la troisième couche de transition thermomécanique 273 de la première superposition par des brasures 30.

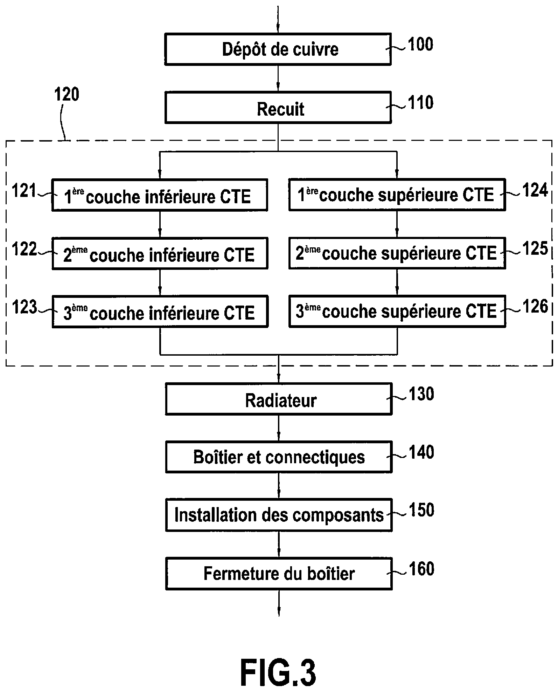

Sur la figure 3 est représenté un logigramme d'un procédé de fabrication du module électronique de puissance 20 de la figure 2 selon un mode de mise en œuvre de l'invention.

Dans une première étape 100 du procédé, une pâte de cuivre compatible avec la céramique de la plaque 24 est déposée par sérigraphie en couche mince, typiquement entre 20 et 50 µm, sur la seconde face 24b de la plaque isolante 24 en céramique, la seconde face 24b correspondant à la face inférieure sur la figure 2, et sur la première face 24a qui correspond à la face supérieure sur la figure 2. Sur la première face 24a, la pâte de cuivre est déposée avec les motifs des pistes électriques envisagées alors que sur la seconde face 24b, la pâte de cuivre est déposée en pleine plaque, c'est-à-dire en couvrant toute la face inférieure 24b de la plaque isolante 24, la face inférieure 24b étant destinée au refroidissement du module électronique 20.

Les pâtes de cuivre peuvent être, par exemple, des pates industrielles de type Heraeus ou C7720 qui sont compatibles avec une plaque en céramique Al₂O₃, ou bien des pâtes de type C7403 ou C7404 qui sont compatibles avec une céramique en AIN.

Le procédé peut également comprendre, dans des variantes, l'utilisation d'autres techniques de dépôt de couches métalliques minces à partir des pâtes ou des encres comme les techniques dites de direct writing process (inkjet process, extrusion based process, aerosol based process,...).

Dans une étape suivante 110, un recuit des première et seconde couches de pâte de cuivre 25a et 25b est ensuite réalisé à une température de l'ordre de 700 °C pour éliminer les solvants et les autres matières organiques et pour fritter les particules de cuivre.

Les première et seconde couches de cuivre 25a et 25b obtenues après le recuit assurent une bonne adhésion à la céramique de la plaque isolante 24 et présentent une bonne soudabilité pour la couche de transition thermomécanique, respectivement 271 et 274, qui sera agglomérée sur la couche de cuivre correspondante 25a ou 25b par un échauffement local produit par un laser ou un faisceau d'électrons par exemple.

Dans une étape suivante 120 du procédé, on réalise une étape de formation des couches de transition thermomécanique 271 à 276 sur les couches de cuivre 25a et 25b.

Pour la face inférieure du module électronique de puissance 20 formée à partir de la face inférieure 24b de la plaque isolante 24, des lits de poudre avec des matériaux ayant des CTE entre 7 et 17 ppm/°C sont déposées sur la seconde couche de cuivre 25b puis figées successivement par le balayage de la source de puissance sous atmosphère inerte, par exemple à l'aide d'Argon, sur toute la surface pour avoir une surface plane.

Plus précisément, dans une première étape 121 de formation des couches de transition thermomécanique, on forme une première couche de transition thermomécanique 274 de la seconde superposition 27b sur la seconde couche de cuivre 25b en déposant un lit de poudre d'un matériau présentant un CTE de 13 ppm/°C sur toute la surface de la seconde couche de cuivre 25b, puis on fige la première couche de transition thermomécanique 274 de la seconde superposition 27b par le balayage d'un laser par exemple, sous atmosphère inerte sur toute la surface de la face inférieure 24b de la plaque de céramique 24.

Dans une deuxième étape 122 de formation des couches de transition thermomécanique, on forme une deuxième couche de transition thermomécanique 275 de la seconde superposition 27b en déposant sur la première couche de transition thermomécanique 274 un lit de poudre d'un matériau présentant un CTE de 10 ppm/°C sur toute la surface de la première couche de transition thermomécanique 274, puis on fige la deuxième couche de transition thermomécanique 275 de la seconde superposition 27b par le balayage d'un laser par exemple, sous atmosphère inerte sur toute la surface de la face inférieure 24b de la plaque de céramique 24.

Dans une troisième étape 123 de formation des couches de transition thermomécanique, on forme une troisième couche de transition thermomécanique 276 de la seconde superposition 27b en déposant sur la deuxième couche de transition thermomécanique 275 un lit de poudre d'un matériau présentant un CTE de 7 ppm/°C sur toute la surface de la deuxième couche de transition thermomécanique 275, puis on fige la troisième couche de transition thermomécanique 276 de la seconde superposition 27b par le balayage d'un laser par exemple, sous atmosphère inerte sur toute la surface de la face inférieure 24b de la plaque de céramique 24.

Pour la face supérieure du module électronique de puissance 20 formée à partir de la face supérieure 24a de la plaque isolante 24, les mêmes étapes que la face inférieure sont réalisées à l'exception que le balayage de la source de puissance ne couvre pas toute la surface étant donnée que la première couche de cuivre 25a ne couvre pas toute la surface mais forme des pistes électriques sur la face supérieure de la plaque isolante 24.

Plus précisément, dans une quatrième étape 124 de formation des couches de transition thermomécanique, on forme une première couche de transition thermomécanique 271 de la première superposition 27a sur la première couche de cuivre 25a en déposant un lit de poudre d'un matériau présentant un CTE de 13 ppm/°C uniquement sur les pistes formées par la première couche de cuivre 25a, puis on fige la première couche de transition thermomécanique 271 de la première superposition 27a par le balayage d'un laser par exemple, sous atmosphère inerte sur les pistes ainsi formées.

Dans une cinquième étape 125 de formation des couches de transition thermomécanique, on forme une deuxième couche de transition thermomécanique 272 de la première superposition 27a en déposant sur la première couche de transition thermomécanique 271 un lit de poudre d'un matériau présentant un CTE de 10 ppm/°C uniquement sur les pistes formées par la première couche de transition thermomécanique 271 et la première couche de cuivre 25a, puis on fige la deuxième couche de transition thermomécanique 272 de la première superposition 27a par le balayage d'un laser par exemple, sous atmosphère inerte sur les pistes ainsi formées.

Dans une sixième étape 126 de formation des couches de transition thermomécanique, on forme une troisième couche de transition thermomécanique 273 de la première superposition 27a en déposant sur la deuxième couche de transition thermomécanique 272 un lit de poudre d'un matériau présentant un CTE de 7 ppm/°C uniquement sur les pistes formées par la deuxième couche de transition thermomécanique 272, la première couche de transition thermomécanique 271 et la première couche de cuivre 25a, puis on fige la troisième couche de transition thermomécanique 273 de la première superposition 27a par le balayage d'un laser par exemple, sous atmosphère inerte sur les pistes ainsi formées.

La dernière couche supérieure de la première superposition 27a, c'est-à-dire la troisième couche de transition thermomécanique 273, présente de préférence un CTE le plus proche possible de celui des composants semi-conducteurs 26 qui sont généralement brasés sur cette couche, c'est-à-dire l'ordre de 3 à 4 ppm/°C.

En cas de forte rugosité de cette dernière couche 273, une étape de polissage peut être prévue pour atteindre la rugosité nécessaire.

Le procédé peut également comprendre, dans des variantes, des dépôts de finitions sur la dernière couche supérieure 273 classiquement utilisés en assemblage électronique de type ENIG (« Electroless Nickel Immersion gold »), ENEPIG (« Electroless Nickel Electroless Palladium Immersion Gold »), EPIG (« Electroless Palladium and Immersion Gold plating »), ISIG (« Immersion Silver and Immersion Gold plating »), etc., pour éviter l'oxydation lors du brasage des composants à semi-conducteurs de puissance 26 et avoir une compatibilité avec les technologies et les procédés d'attache de composants classiquement utilisées.

Pour la formation des couches de transition thermomécaniques, des projections de poudre peuvent aussi être envisagées pour remplacer les lits de poudre.

La variation de CTE des couches est assurée par la variation de la concentration des poudres ou des fibre du matériau à faible CTE (W, Mo, Invar, Kovar, diamant, SiC, fibre de carbone...) dans les matériaux à fort CTE (Cu).

Les matériaux des poudres utilisées pour les couches de transition thermomécanique peuvent être par exemple choisis dans la liste suivante : W50Cu50, W60Cu40, W70Cu30, W80Cu20, W90Cu10, Mo50Cu50, Mo60Cu40, Mo70Cu30, Mo80Cu20, Mo85Cu15.

La puissance de la source de chaleur doit permettre de faire fondre au moins un des matériaux du mélange pour assurer une bonne incorporation des particules dans une matrice métallique. Parmi les matériaux déjà cités, le cuivre présente la température de fusion la plus faible et il faut donc au moins une puissance et un temps permettant d'atteindre la température de fusion de Cu qui est de 1085°C.

L'épaisseur de chaque couche de cuivre ou de chaque couche de transition thermomécanique déposée varie entre 20 µm et 150 µm et le CTE s'approche de celui de la céramique en s'éloignant de l'interface avec la plaque isolante 24 en céramique. Cela permet de diminuer les contraintes mécaniques subites dans la céramique de la plaque isolante 24 lors des variation de température et de distribuer les contraintes entre les différentes couches sans avoir des contraintes excessives entre deux couches métalliques successives menant à la défaillance de l'assemblage.

Le procédé de fabrication comprend en outre, lors de la fabrication de la face inférieure, l'impression des couches continues jusqu'à la fabrication d'un radiateur 23 avec différentes géométries complexes et efficaces pour un refroidissement sous air, comme par exemple des ailettes, des pins, des réseaux « lattices », ou autres, ou des canaux pour un refroidissement par liquide.

Plus précisément, dans une étape 130 du procédé, qui peut être confondue avec la troisième étape 123 de formation des couches de transition thermomécanique dans laquelle est formée la troisième couche de transition thermomécanique 276 de la seconde superposition 27b, on forme un radiateur 23 à partir de la troisième couche de transition thermomécanique 276 de la seconde superposition pour qu'elle comprenne le radiateur 23.

Le procédé de fabrication du module électronique de puissance 20 permet ainsi de réduire la résistance thermique du module 20 en éliminant le matériau d'interface thermique et en permettant la fabrication d'un radiateur 23 avec des géométries complexes très difficilement réalisable par les technologies classiques.

De même, pour la face supérieure, la troisième couche de transition thermomécanique 273 de la première superposition 27a est déposée afin de réaliser les connectiques 29 et le boitier 22 par impression 3D dans une étape 140 qui peut être confondue avec la sixième étape 126 de formation des couches de transition thermomécanique.

Pour finaliser le module électronique de puissance 20, dans une étape 150, les composants à semi-conducteurs de puissance 26 sont ensuite reportés sur la dernière couche 273 de la première superposition 27a par une des techniques utilisés classiquement, telle que le brasage, le collage, ou le frittage par exemple, puis connectés électriquement par exemple par des fils de câblage, par brasage de cadre métallique, ou par d'autre technique d'interconnexion.

Enfin, dans une étape 160, le module électronique 20 est encapsulé, c'est-à-dire rempli par un gel silicone, epoxy, ou par un liquide ou un gaz isolant dans le cas où la fermeture est hermétique et le boitier 22 est fermé par fabrication additive à partir du même matériau que le matériau utilisé pour la troisième couche de transition thermomécanique 273 de la première superposition 27a. Autour des connectiques sortantes 29 et afin d'assurer une isolation électrique du boitier entre les connectiques et le boitier, un joint isolant en verre, en céramique peut être réalisé.

La partie constituant la fermeture du boitier peut être réalisée séparément et attachée au boitier après par brasage, frittage, ou autre technique d'assemblage.

## Revendications

1. Procédé de fabrication d'un module électronique de puissance (20) par fabrication additive, le module électronique (20) comprenant un substrat (21) comportant une plaque électriquement isolante (24) présentant une première et une seconde faces opposées (24a, 24b), et une première couche métallique (25a) disposée directement sur la première face (24a) de la plaque isolante (24) et une seconde couche métallique (25b) disposée directement sur la seconde face (25b) de la plaque isolante (24),
au moins une des couches métalliques (25a) étant réalisée par une étape de dépôt (100) d'une couche mince de cuivre et une étape de recuit (110) de la couche métallique (25a, 25b),
et le procédé comprenant en outre une étape (120) de formation d'au moins une couche de transition thermomécanique (271 à 273, 274 à 276) sur au moins l'une des première et seconde couches métalliques (25a, 25b), ladite au moins une couche de transition thermomécanique (271 à 273, 274 à 276) comportant un matériau présentant un coefficient de dilatation thermique inférieur à celui du métal de la couche métallique (25a, 25b).

2. Procédé selon la revendication 1, dans lequel ladite au moins une couche de transition thermomécanique (271 à 273, 274 à 276) est déposée par dépôt d'un lit de poudre de matériau ou par projections de poudre de matériau, la poudre déposée étant figée par balayage d'une source de puissance calorifique sous atmosphère inerte.

3. Procédé selon l'une des revendications 1 ou 2, dans lequel le coefficient de dilatation thermique des matériaux utilisées pour les couches de transition thermomécanique (271 à 273, 274 à 276) est compris entre 3 ppm/°C et 17 ppm/°C.

4. Procédé selon l'une des revendications 1 à 3, dans lequel le substrat (21) comprend, sur au moins une des première et seconde faces (24a, 24b) de la plaque isolante (24), un empilement (28a, 28b) d'une couche métallique (25a, 25b) et d'une pluralité de couches de transition thermomécanique (271 à 273, 274 à 276), ledit au moins un empilement (28a, 28b) présentant un gradient de coefficient de dilatation thermique.

5. Procédé selon l'une des revendications 1 à 4, comprenant en outre une étape (130) de formation d'un radiateur par fabrication additive à partir de la dernière couche de transition thermomécanique (276) de la seconde face du substrat (21).

6. Procédé selon l'une des revendications 1 à 5, comprenant en outre, une étape (140) de réalisation d'un boîtier (22) à apte à protéger les composants électroniques (26) destinés à être montés sur la première face du substrat (21) et de réalisation des connectiques (29) aptes à raccorder électriquement le module électronique (20) à des éléments électriques externes, le boîtier (22) et les connectiques (29) étant réalisés par fabrication additive à partir de la dernière couche de transition thermomécanique (273) de la première face du substrat (21).

7. Substrat (21) pour module électronique de puissance (20), le substrat (21) comportant une plaque électriquement isolante (24) présentant une première et une seconde faces opposées (24a, 24b), et une première couche métallique (25a) disposée directement sur la première face (24a) de la plaque isolante (24) et une seconde couche métallique (25b) disposée directement sur la seconde face (24b) de la plaque isolante (24), comprenant sur au moins l'une des première et seconde couches métalliques (25a, 25b), au moins une couche de transition thermomécanique (271 à 273, 274 à 276) comportant un matériau présentant un coefficient de dilatation thermique inférieur à celui du métal de la couche métallique (25a, 25b), et au moins un empilement (28a, 28b) d'une couche métallique (25a, 25b) et d'une pluralité de couches de transition thermomécanique (271 à 273, 274 à 276), ledit au moins un empilement (28a, 28b) présentant un gradient de coefficient de dilatation thermique.

8. Substrat (21) selon la revendication 7, dans lequel le coefficient de dilatation thermique des matériaux utilisés pour les couches de transition thermomécanique (271 à 273, 274 à 276) est compris entre 3 ppm/°C et 17 ppm/°C.

9. Module électronique de puissance (20) comprenant un substrat présentant une première face et une seconde face opposée à la première face, et un radiateur (23) monté sur la seconde face du substrat, la première face du substrat étant destinée à recevoir des composants électroniques (26),
**caractérisé en ce que** le substrat est un substrat (21) selon l'une des revendications 7 ou 8.

10. Module électronique de puissance (20) selon la revendication 9, dans lequel le radiateur (23) comprend la dernière couche de transition thermomécanique (276) de la seconde face du substrat (21), le radiateur (23) étant réalisé par fabrication additive à partir de ladite dernière couche de transition thermomécanique (276) de la seconde face du substrat (21).

11. Module électronique de puissance (20) selon l'une des revendications 9 ou 10, comprenant en outre un boîtier (22) apte à protéger les composants électroniques (26) montés sur la première face du substrat (21), le boîtier (22) étant réalisé par fabrication additive à partir de la dernière couche de transition thermomécanique (273) de la première face du substrat (21).

## Patentansprüche

1. Verfahren zur Herstellung eines leistungselektronischen Moduls (20) durch generative Fertigung, wobei das elektronische Modul (20) ein Substrat (21) umfasst, das eine elektrisch isolierende Platte (24) aufweist, die eine erste und eine zweite Fläche (24a, 24b) aufweisen, die sich gegenüberliegen, und eine erste Metallschicht (25a), die direkt auf der ersten Fläche (24a) der isolierenden Platte (24) angeordnet ist, und eine zweite Metallschicht (25b), die direkt auf der zweiten Fläche (24b) der isolierenden Platte (24) angeordnet ist,
wobei mindestens eine der Metallschichten (25a) durch einen Schritt des Aufbringens (100) einer dünnen Kupferschicht und einen Schritt des Glühens (110) der Metallschicht (25a, 25b) hergestellt wird,
und wobei das Verfahren ferner einen Schritt des Bildens (120) mindestens einer thermomechanischen Übergangsschicht (271 bis 273, 274 bis 276) auf mindestens einer von der ersten und zweiten Metallschicht (25a, 25b) umfasst, wobei die mindestens eine thermomechanische Übergangsschicht (271 bis 273, 274 bis 276) ein Material umfasst, das einen Wärmeausdehnungskoeffizienten umfasst, der niedriger als der des Metalls der Metallschicht (25a, 25b) ist.

2. Verfahren nach Anspruch 1, wobei die mindestens eine thermomechanische Übergangsschicht (271 bis 273, 274 bis 276) durch Aufbringen eines Materialpulverbetts oder durch Sprühen von Materialpulver aufgebracht wird, wobei das aufgebrachte Pulver durch Scannen mit einer Heizleistungsquelle unter inerter Atmosphäre gefestigt wird.

3. Verfahren nach einem der Ansprüche 1 oder 2, wobei der Wärmeausdehnungskoeffizient der für die thermomechanischen Übergangsschichten (271 bis 273, 274 bis 276) verwendeten Materialien zwischen 3 ppm/°C und 17 ppm/°C liegt.

4. Verfahren nach einem der Ansprüche 1 bis 3, wobei das Substrat (21) auf mindestens einer von der ersten und zweiten Fläche (24a, 24b) der isolierenden Platte (24) einen Stapel (28a, 28b) aus einer Metallschicht (25a, 25b) und einer Vielzahl von thermomechanischen Übergangsschichten (271 bis 273, 274 bis 276) umfasst, wobei der mindestens eine Stapel (28a, 28b) einen Wärmeausdehnungskoeffizientgradienten aufweist.

5. Verfahren nach einem der Ansprüche 1 bis 4, umfassend ferner einen Schritt (130) des Bildens eines Heizkörpers durch generative Fertigung ausgehend von der letzten thermomechanischen Übergangsschicht (276) der zweiten Fläche des Substrats (21).

6. Verfahren nach einem der Ansprüche 1 bis 5, umfassend ferner einen Schritt (140) des Herstellens eines Gehäuses (22), das imstande ist, die elektronischen Komponenten (26) zu schützen, die zum Anbringen auf der ersten Fläche des Substrats (21) bestimmt sind, und des Herstellens der Anschlüsse (29), die imstande sind, das elektronische Modul (20) an externe elektrische Elemente elektrisch anzuschließen, wobei das Gehäuse (22) und die Anschlüsse (29) durch generative Fertigung ausgehend von der letzten thermomechanischen Übergangsschicht (273) der ersten Fläche des Substrats (21) hergestellt werden.

7. Substrat (21) für ein leistungselektronisches Modul (20), wobei das Substrat (21) eine elektrisch isolierende Platte (24) aufweist, die eine erste und eine zweite Fläche (24a, 24b) aufweist, die sich gegenüberliegen, und eine erste Metallschicht (25a), die direkt auf der ersten Fläche (24a) der isolierenden Platte (24) angeordnet ist, und eine zweite Metallschicht (25b), die direkt auf der zweiten Fläche (24b) der isolierenden Platte (24) angeordnet ist,
umfassend, auf mindestens einer von der ersten und zweiten Metallschicht (25a, 25b), mindestens eine thermomechanische Übergangsschicht (271 bis 273, 274 bis 276), die ein Material umfasst, das einen Wärmeausdehnungskoeffizienten umfasst, der niedriger als der des Metalls der Metallschicht (25a, 25b) ist, und mindestens einen Stapel (28a, 28b) einer Metallschicht (25a, 25b) und einer Vielzahl von thermomechanischen Übergangsschichten (271 bis 273, 274 bis 276), wobei der mindestens eine Stapel (28a, 28b) einen Wärmeausdehnungskoeffizientgradienten aufweist.

8. Substrat (21) nach Anspruch 7, wobei der Wärmeausdehnungskoeffizient der für die thermomechanischen Übergangsschichten (271 bis 273, 274 bis 276) verwendeten Materialien zwischen 3 ppm/°C und 17 ppm/°C liegt.

9. Leistungselektronisches Modul (20), umfassend ein Substrat, das eine erste Fläche und eine zweite Fläche gegenüber der ersten Fläche aufweist, und einen Heizkörper (23), der auf der zweiten Fläche des Substrats angebracht ist, wobei die erste Fläche des Substrats bestimmt ist, elektronische Komponenten (26) aufzunehmen,
**dadurch gekennzeichnet, dass** das Substrat ein Substrat (21) nach einem der Ansprüche 7 oder 8 ist.

10. Leistungselektronisches Modul (20) nach Anspruch 9, wobei der Heizkörper (23) die letzte thermomechanische Übergangsschicht (276) der zweiten Fläche des Substrats (21) umfasst, wobei der Heizkörper (23) durch generative Fertigung ausgehend von der letzten thermomechanischen Übergangsschicht (276) der zweiten Fläche des Substrats (21) hergestellt ist.

11. Leistungselektronisches Modul (20) nach einem der Ansprüche 9 oder 10, umfassend ferner ein Gehäuse (22), das imstande ist, die auf der ersten Fläche des Substrats (21) angebrachten elektronischen Komponenten (26) zu schützen, wobei das Gehäuse (22) durch generative Fertigung ausgehend von der letzten thermomechanischen Übergangsschicht (273) der zweiten Fläche des Substrats (21) hergestellt ist.

## Claims

1. A method of fabricating an electronic power module (20) by additive manufacturing, the electronic module (20) comprising a substrate (21) having an electrically insulating plate (24) presenting opposite first and second faces (24a, 24b), with a first metal layer (25a) arranged directly on the first face (24a) of the insulating plate (24), and a second metal layer (25b) arranged directly on the second face (24b) of the insulating plate (24);
at least one of the metal layers (25a) being made by a step (100) of depositing a thin layer of copper and a step (110) of annealing the metal layer (25a, 25b); and
the method further comprising a step (120) of forming at least one thermomechanical transition layer (271 to 273, 274 to 276) on at least one of the first and second metal layers (25a, 25b), said at least one thermomechanical transition layer (271 to 273, 274 to 276) comprising a material presenting a coefficient of thermal expansion that is less than that of the metal of the metal layer (25a, 25b).

2. A method according to claim 1, wherein said at least one thermomechanical transition layer (271 to 273, 274 to 276) is deposited by depositing a powder bed of material or by spraying powder material, the deposited powder being set by scanning with a heat power source in an inert atmosphere.

3. A method according to claim 1 or claim 2, wherein the coefficients of thermal expansion of the materials used for the thermomechanical transition layers (271 to 273, 274 to 276) lie in the range 3 ppm/°C to 17 ppm/°C.

4. A method according to any one of claims 1 to 3, wherein the substrate (21) comprises, on at least one of the first and second faces (24a, 24b) of the insulating plate (24), a stack (28a, 28b) of a metal layer (25a, 25b) and a plurality of thermomechanical transition layers (271 to 273, 274 to 276), with said at least one stack (28a, 28b) presenting a gradient in its coefficient of thermal expansion.

5. A method according to any one of claims 1 to 4, further comprising a step (130) of forming a radiator by additive manufacturing from the last thermomechanical transition layer (276) of the second face of the substrate (21).

6. A method according to any one of claims 1 to 5, further comprising a step (140) of making a package (22) suitable for protecting the electronic components (26) that are to be mounted on the first face of the substrate (21) and of making connections (29) suitable for electrically connecting the electronic module (20) to external electrical elements, the package (22) and the connections (29) being made by additive manufacturing from the last thermomechanical transition layer (273) of the first face of the substrate (21).

7. A substrate (21) for an electronic power module (20), the substrate (21) comprising an electrically insulating plate (24) presenting opposite first and second faces (24a, 24b), with a first metal layer (25a) arranged directly on the first face (24a) of the insulating plate (24), and a second metal layer (25b) arranged directly on the second face (24b) of the insulating plate (24);
the substrate comprising, on at least one of the first and second metal layers (25a, 25b), at least one thermomechanical transition layer (271 to 273, 274 to 276) comprising a material presenting a coefficient of thermal expansion less than the coefficient of thermal expansion of the metal of the metal layer (25a, 25b), and at least one stack (28a, 28b) of a metal layer (25a, 25b) and a plurality of thermomechanical transition layers (271 to 273, 274 to 276), said at least one stack (28a, 28b) presenting a gradient in its coefficient of thermal expansion.

8. A substrate (21) according to claim 7, wherein the coefficients of thermal expansion of the materials used for the thermomechanical transition layers (271 to 273, 274 to 276) lie in the range 3 ppm/°C to 17 ppm/°C.

9. An electronic power module (20) comprising a substrate presenting a first face and a second face opposite from the first face, and a radiator (23) mounted on the second face of the substrate, the first face of the substrate being for receiving electronic components (26), the module being **characterized in that** the substrate is a substrate (21) according to either one of claims 7 and 8.

10. An electronic power module (20) according to claim 9, wherein the radiator (23) comprises the last thermomechanical transition layer (276) of the second face of the substrate (21), the radiator (23) being made by additive manufacturing from the last thermomechanical transition layer (276) of the second face of the substrate (21) .

11. An electronic power module (20) according to claim 9 or claim 10, further comprising a package (22) suitable for protecting the electronic components (26) mounted on the first face of the substrate (21), the package (22) being made by additive manufacturing from the last thermomechanical transition layer (273) of the first face of the substrate (21).
